**Europäisches Patentamt**

**European Patent Office**

**Office européen des brevets**

(19)

(11) Veröffentlichungsnummer: **0 215 392**
**B1**

(12) **EUROPÄISCHE PATENTSCHRIFT**

(45) Veröffentlichungstag der Patentschrift: **11.04.90**

(21) Anmeldenummer: **86112279.4**

(22) Anmeldetag: **05.09.86**

(51) Int. Cl.⁵: **B 29 C 43/22**

(54) Doppelbandpresse zur kontinuierlichen Herstellung kupferkaschierter Laminate.

(30) Priorität: **19.09.85 DE 3533413**

(43) Veröffentlichungstag der Anmeldung:
**25.03.87 Patentblatt 87/13**

(45) Bekanntmachung des Hinweises auf die
Patenterteilung:
**11.04.90 Patentblatt 90/15**

(84) Benannte Vertragsstaaten:
**FR GB IT SE**

(56) Entgegenhaltungen:
**EP-A-0 120 192**
**EP-A-0 144 822**
**US-A-2 909 804**

(73) Patentinhaber: **Held, Kurt**
**Alte Strasse 1**
**D-7218 Trossingen 2 (DE)**

(72) Erfinder: **Held, Kurt**
**Alte Strasse 1**
**D-7218 Trossingen 2 (DE)**

Courier Press, Leamington Spa, England.

## Beschreibung

Die Erfindung betrifft eine Doppelbandpresse zur kontinuierlichen Herstellung kupferkaschierter Laminate gemäss dem Oberbegriff des Patentanspruchs 1.

Kupferkaschierte Laminate, die als Ausgangsmaterialien zur Herstellung von Leiterplatten dienen, bestehen aus einem Schichtstoffkern, der auf mindestens einer Oberfläche eine galvanisch abgeschiedene, fest mit der Oberfläche verbundene Kupferfolie besitzt. Der Schichtstoffkern wiederum setzt sich aus einzelnen Lagen von mit duroplastischem Harz getränkten Trägermaterialien zusammen, beispielsweise aus mit Epoxyharz imprägnierten Glasfasergeweben, die gleichzeitig mit der Kupferfolie unter Hitze und Druck verpresst werden. Bei der Verpressung ist es wichtig, dass auf den äusseren, dem Schichtstoffkern abgewandten Oberflächen der Kupferfolie weder Staubteilchen noch sonstige Fremdkörper eingedrückt werden, da ansonsten Fehlstellen im kupferkaschierten Laminat entstehen, die zu Funktionsfehlern der Leiterplatte und letztendlich zu Ausschuss führen.

Zur kontinuierlichen Herstellung solcher kupferkaschierten Laminate ist ein mit einer Doppelbandpresse arbeitendes Verfahren und eine, auf welcher der Oberbegriff des Patentanspruchs 1 basiert, Vorrichtung aus der Offenlegungsschrift DE-OS 33 07 057 bekannt. Bei diesem Verfahren werden die Trägermaterialbahnen sowie die Kupferfolien kontinuierlich von Rollen abgezogen, entsprechend dem gewünschten Aufbau zu einem Schichtgebilde zusammengeführt und in einer Doppelbandpresse zu einer kontinuierlich vorlaufenden kupferkaschierten Laminatbahn verpresst. Aus dieser Offenlegungsschrift ist es bekannt, aus elastischen Materialien bestehende Abstreifer in der Nähe des Einlaufes in die Doppelbandpresse anzuordnen. Diese Abstreifer liegen sowohl auf den Oberflächen der Pressbänder der Doppelbandpresse als auch auf den dem Schichtstoffkern abgewandten Oberflächen der Kupferfolien auf, streifen dabei den Schmutz von diesen Oberflächen ab und sammeln diesen in einer Rinne an, von wo er dann herausgespült wird.

Es hat sich gezeigt, dass solche Abstreifer nicht in der Lage sind, sämtliche auf den metallischen Oberflächen durch elektrostatische Anziehung haftende Staubkörner zu entfernen. Insbesondere besteht die Gefahr, dass dieser Staub nur aufgewirbelt wird und sich anschliessend wieder auf den Oberflächen absetzt und bei der Verpressung dann schädliche Eindrücke auf der Oberfläche des kupferkaschierten Laminats hinterlässt. Weiter nachteilig ist, dass das durch Pinholes in der Kupferoberfläche bei der Verpressung von den Trägermaterialien auf das Pressband hindurchgeflossene und dort gehärtete Harz, das eventuell noch mit aus der Kupferfolienoberfläche bei der Trennung der Laminatbahn von den Pressbändern am Auslauf der Doppelbandpresse herausgerissenen Kupferteilen verbunden ist, mit einem solchen Abstreifer nicht entfernt werden kann, da es festhaftend mit der Pressbandoberfläche verbunden ist. Solche Rückstände laufen daher mit dem Pressband erneut in den Einlauf der Doppelbandpresse ein und führen zu periodisch auftretenden Fehlstellen in der Laminatbahn. Ausserdem bauen sie sich immer weiter auf, da nach jedem Durchlauf des Pressbandes neue Rückstände hinzukommen können, ohne dass die alten entfernt waren. Mit solchen Abstreifern ist daher ein wartungsfreier Langzeitbetrieb auf keinem Fall möglich.

Der Erfindung liegt die Aufgabe zugrunde, eine Vorrichtung an einer zur kontinuierlichen Herstellung von kupferkaschierten Laminaten dienenden Doppelbandpresse anzugeben, die zur sicheren Entfernung sämtlichen Schmutzes, Staubes und festsitzenden Harzes sowohl auf den Pressbändern der Doppelbandpresse als auch auf der Kupferfolie geeignet ist, so dass Fehlstellen in der Laminatoberfläche durch Eindrücke solcher Schmutzteilchen bei der Verpressung mit Sicherheit vermieden werden.

Die Lösung dieser Aufgabe wird durch die im Patentanspruch 1 beschriebene technische Lehre vermittelt.

Besondere Ausführungsarten der Erfindung sind in den abhängigen Patentansprüchen 2 bis 32 angegeben.

Die mit der Erfindung erzielbaren Vorteile bestehen darin, dass die Pressbandoberfläche vor der Einlaufzone vollständig von Schmutz, festsitzenden Harzresten, usw. gereinigt ist ebenso wie die aussenliegende Oberfläche der Kupferfolie von sämtlichen Staubpartikeln, abgebrochenen Dentriten, die beim Treatment zur Haftungsverbesserung auf der dem Schichtstoffkern zugewandten Oberfläche der Kupferfolie gebildet werden, usw. befreit ist. Nach dieser Reinigung liegt die Aussenoberfläche der Kupferfolie auf der Pressbandoberfläche bis nach der Verpressung auf, womit sich kein neuer Staub mehr absetzen kann. Es werden somit kupferkaschierte Laminate hergestellt, die frei von Fehlstellen und von bisher unbekannter Qualität sind.

Ein bevorzugtes Ausführungsbeispiel der Erfindung wird im folgenden näher beschrieben. Es zeigen

Fig. 1 eine Produktionsanlage zur kontinuierlichen Herstellung von kupferkaschierten Elektrolaminaten,

Fig. 2 eine Doppelbandpresse schematisch in Seitenansicht,

Fig. 3 die Pressbandschleifeinrichtung in perspektivischer Ansicht von der Rückseite der Doppelbandpresse gesehen,

Fig. 4 eine Draufsicht auf die Pressbandschleifeinrichtung,

Fig. 5 einen Teilschnitt in perspektivischer Ansicht des Schleifkissens,

Fig. 6 einen Schnitt entlang der Linie A-A aus Fig. 4 durch die Pressbandschleifeinrichtung,

Fig. 7 einen Schnitt durch die Einlaufzone der Doppelbandpresse mit der Wischeinrichtung,

Fig. 8 eine Draufsicht auf eine mit einer Kette gebildete Pressbandschleifeinrichtung und

Fig. 9 eine Draufsicht auf eine Pressbandschleifeinrichtung, die durch zwei Schleifwalzen gebildet wird.

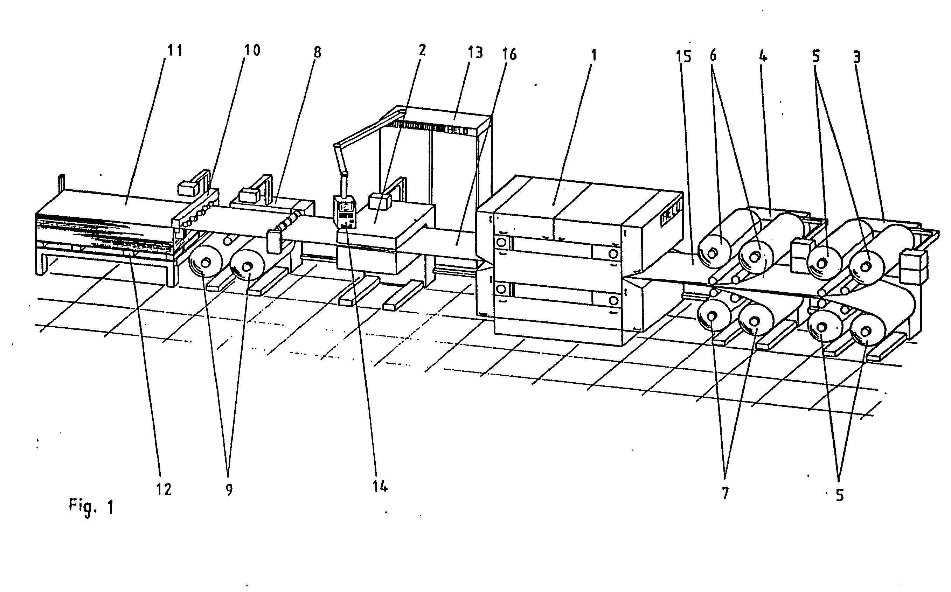

In Fig. 1 ist eine Produktionsanlage zur kontinuierlichen Herstellung von kupferkaschierten Laminaten schematisch dargestellt. Vor der Doppelbandpresse 1 befinden sich hintereinander angeordnete Abwickeleinheiten 3, 4, deren Anzahl sich nach dem Aufbau des kupferkaschierten Laminats richtet. Die Abwickeleinheit 3 trägt Rollen 5 für die mit vorkondensierten Duroplastharzen getränkten Schichtstoffbahnen, beispielsweise mit Epoxyharz getränkte Glasgewebebahnen, während die Abwickeleinheit 4 Rollen 6, 7 für die elektrolytisch abgeschiedene Kupferfolie trägt. Von den Rollen 5 werden die Schichtstoffbahnen für den isolierenden Schichtstoffkern des kupferkaschierten Laminats abgezogen und mit den Kupferfolien von den Rollen 6, 7 zu einem Schichtgebilde 15 zusammengeführt. Dieses Schichtgebilde 15 wird anschliessend in einer Doppelbandpresse 1 unter Einwirkung von Wärme und Flächendruck zu einer Laminatbahn 16 verpresst, die nach Verlassen der Doppelbandpresse 1 mit gleichförmiger Geschwindigkeit durch eine Kühleinrichtung 2 hindurchläuft. Falls es sich um eine flexible kupferkaschierte Laminatbahn handelt, kann diese anschliessend in einer Wickelstation 8 auf Rollen 9 aufgewickelt werden. Alternativ kann die Laminatbahn 16 in einer Schneidestation 10 in Platten 11 aufgeteilt werden, die in Paletten 12 gestapelt werden. Die gesamte Produktionsanlage wird von einem Computer in einem Schaltschrank 13 gesteuert. Die Dateneingabe durch den Benutzer erfolgt über das Terminal 14.

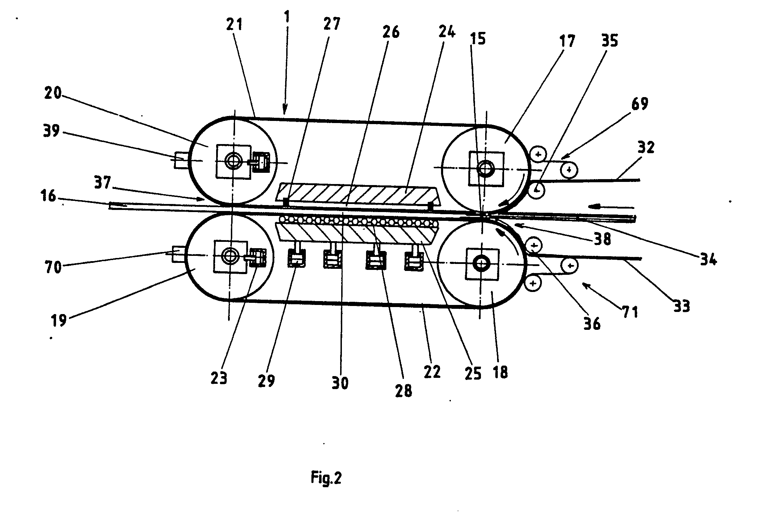

Die kontinuierlich arbeitende Doppelbandpresse 1 wird in Fig. 2 gezeigt. Sie besitzt vier in einem Pressengestell gelagerte Umlenktrommeln 17, 18, 19, 20. Das Pressengestell ist in der Zeichnung der Übersichtlichkeit halber weggelassen. Um jeweils zwei der Umlenktrommeln, die sich entsprechend der Pfeile in den Umlenktrommeln 17 und 18 drehen, ist ein Pressband 21, 22 herumgeführt, das mittels Hydraulikzylindern 23 gespannt wird. Zwischen den Pressbändern 21, 22 wird das in der Zeichnung von rechts nach links vorlaufende Schichtgebilde 15 verpresst.

Der auf das Schichtgebilde 15 ausgeübte Druck wird über Druckplatten 24, 25 hydraulisch oder mechanisch auf die Innenseiten der Pressbänder 21, 22 aufgebracht und von dort, in der sogenannten Reaktionszone 30, auf das Schichtgebilde 15 übertragen. Bei der hydraulischen Druckübertragung wird in dem Raum 26, der nach oben und unten von der Druckplatte 24 bzw. der Pressbandinnenseite 21 und zu den Seiten von der Dichtung 27 begrenzt wird, ein unter Druck setzbares, fluides Druckmedium, beispielsweise Öl oder Luft, eingebracht. Zur mechanischen Druckübertragung, die ebenfalls in Fig. 2 an der unteren Pressbandeinheit erläutert wird, sind zwischen der Druckplatte 25 und der Pressbandinnenseite 22 ortsfeste Rollen 28 angebracht. Mit Hilfe von Hydraulikzylindern 29 werden die Druckplatte 25 und damit die Rollen 28 gegen die Innenseite des Pressbandes 22 angestellt. Falls gewünscht, kann die Druckübertragung auch kombiniert hydraulisch/mechanisch erfolgen, indem die beiden geschilderten Prinzipien gleichzeitig angewandt werden.

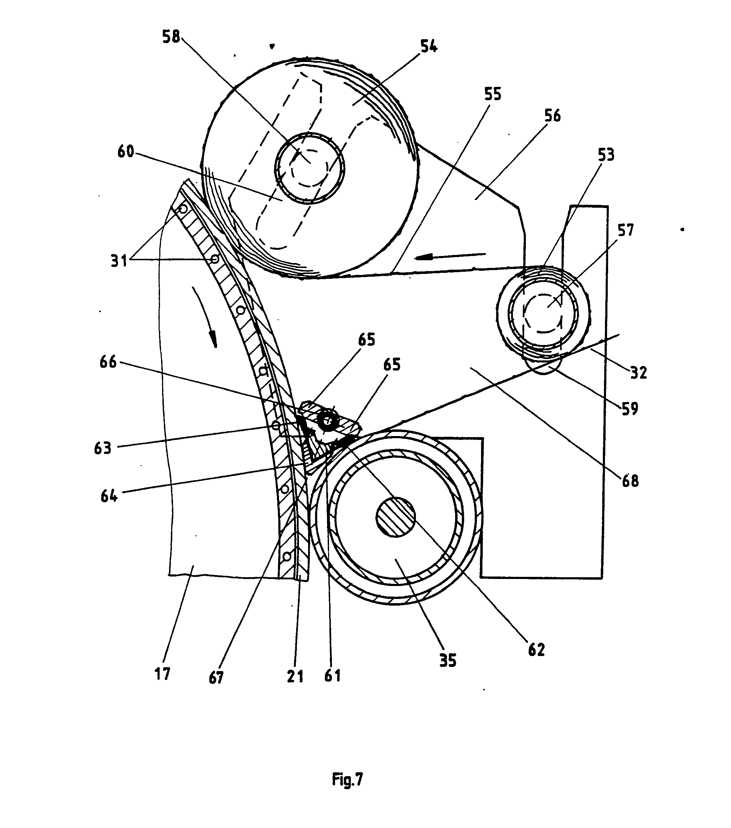

Die einlaufseitigen Umlenktrommeln 17, 18 sind beheizt. Dazu sind in der Nähe der Mantelfläche der Umlenktrommeln 17, 18 Bohrungen 31 angebracht, wie in Fig. 7 gezeigt, die von erwärmten Thermoöl durchflossen werden. Dadurch wird die Mantelfläche der Umlenktrommeln und durch Wärmeleitung weiter das anliegende Pressband 21 bzw. 22 erwärmt. Die von den Pressbändern 21, 22 gespeicherte Wärme wird aufgrund deren Wärmekapazität in die Reaktionszone 30 transportiert und dort an das Schichtgebilde 15 abgegeben. Falls diese Wärme zur Aushärtung des Schichtgebildes 15 nicht ausreicht, können zusätzliche Wärmebrücken im Raum 26 vorhanden sein, die weitere Wärme von der ebenfalls beheizten Druckplatte 24 auf das Pressband 21 übertragen. Die Ausbildung solcher Wärmebrücken kann nach der Offenlegungsschrift DE-OS 33 25 578 erfolgen.

Wie in Fig. 2 und 7 zu sehen ist, werden die einlaufenden Kupferfolienbahnen 32, 33, bevor sie mit den Schichtstoffbahnen 34 zu dem Schichtgebilde 15 zusammengeführt werden, so geführt, dass sie an den Pressbändern 21, 22 der einlaufseitigen Umlenktrommeln 17, 18 anliegen. Dazu dienen die Umlenkrollen 35, 36, die als gummierte Walzen ausgebildet sind und die Kupferfolienbahnen 32, 33 an das jeweilige Pressband 21, 22 anpressen. Dadurch wird die Kupferfolienbahn 32, 33 auf Verfahrenstemperatur erwärmt und eine Faltenbildung der Kupferfolie aufgrund unterschiedlicher Wärmedehnungen bei der Verpressung mit den Schichtstoffbahnen wird vermieden.

Weiterhin wichtig für die Herstellung eines qualitativ hochwertigen kupferkaschierten Laminats ist, dass sowohl die Pressbänder 21, 22 der Doppelbandpresse 1 als auch die Oberflächen der Kupferfolienbahnen 32, 33 frei von Verunreinigungen und Schmutz sind. Gerade beim Durchlauf des Schichtgebildes 15 durch die Reaktionszone 30 kommt es vor, dass Harz aus den Schichtstoffbahnen 34 aufgrund des Druckes durch Poren oder Pinholes der Kupferfolienbahnen 32, 33 hindurchfliesst und auf dem Pressband sich absetzt und aushärtet. Meistens verklebt dieses Harz dann gleichzeitig mit der dem Schichtstoff abgewandten Oberfläche der Kupferfolie. Wenn anschliessend das Laminat die Doppelbandpresse am Auslauf verlässt und an den Umlenktrommeln 19, 20 von den Pressbändern 21, 22 getrennt wird, wird diese Verbindung aufgerissen, wobei dann Teile der Kupferfolie mit dem Harz auf dem Pressband kleben bleiben. Diese am Pressband haftenden Harz- und Kupferfolienreste müssen nun vom Pressband entfernt werden ehe sie am Einlauf in die Doppelbandpresse wieder mit der neu einlaufenden Kupferfolie in Berührung kommen, da sich ansonsten diese Verschmutzungen in die Oberfläche der Kupferfolie einpressen und dieselbe zerstören würden, so dass sich damit periodische Fehlstellen in der Elektrolaminatbahn bilden würden.

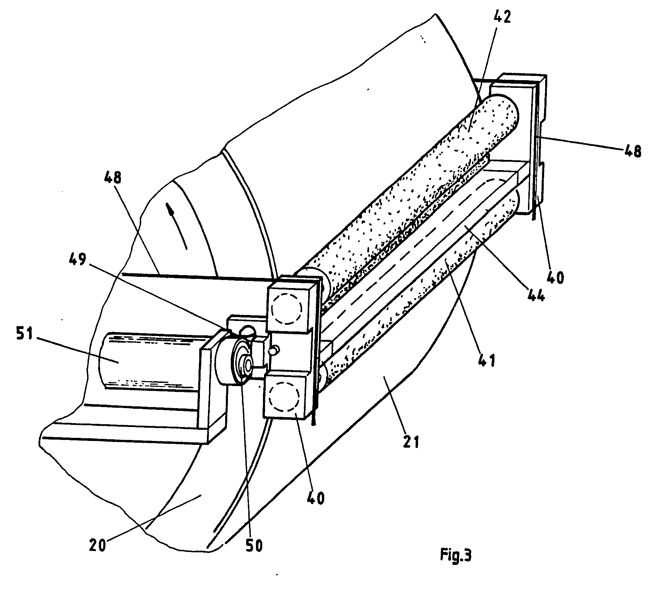

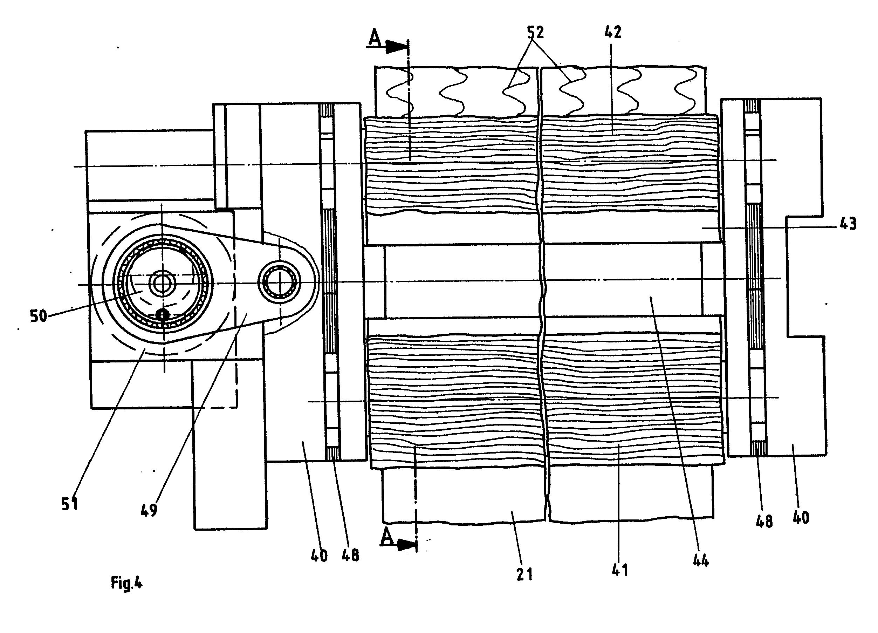

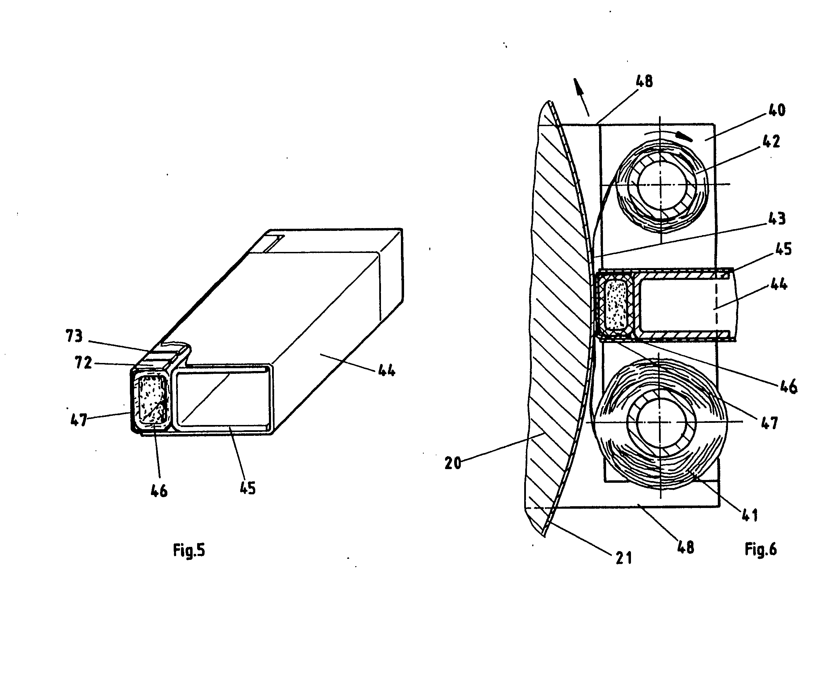

Dazu ist in der Nähe der Auslaufzone 37 der Doppelbandpresse eine Pressbandschleifeinrichtung 39 angebracht, die in Fig. 3 perspektivisch von der Rückseite der Doppelbandpresse 1 aus und in Fig. 4 in Draufsicht, d.h. entgegen der Vorlaufrichtung der Laminatbahn zu sehen ist. Die Pressbandschleifeinrichtung 39 besitzt eine seitlich am Umfang der auslaufseitigen Umlenktrommel 20 befindliche, aus zwei Teilen bestehende Halterung 40, die mittels Blattfedern 48 am Pressengestell der Doppelbandpresse angebracht ist. In dieser Halterung 40 befindet sich zwischen den beiden Teilen drehbar gelagert eine Abwickelrolle 41 für ein bahnförmiges Schleifband 43 mit geeignet gewählter Körnung und eine dazugehörige Aufwickelrolle 42, wobei die Breite des Schleifbandes 43 gleich gross wie diejenige des Pressbandes 21 ist. Das sich zwischen den Rollen 41 und 42 erstreckende Schleifband 43 wird mittels eines Schleifkissens 44 so an das Pressband 21 auf einer Mantelfläche der Umlenktrommel 20 gedrückt, dass dessen Körnung das Pressband 21 mit dem gewünschten Anpressdruck flächig berührt. Das Schleifkissen 44 ist in einem perspektivischen Teilschnitt in Fig. 5 und im Längsschnitt in Fig. 6 zu sehen. Es besitzt ein u-förmig gebogenes Gestell 45, das mit dem dem Pressband zugewandten Ende einen mit Pressluft gefüllten Schlauch 46 abstützt. Die dem Gestell 45 abgewandte Seite des Schlauches 46 ist mit einem ebenfalls u-förmigen dünnen Blech 47, das wiederum am Schleifband 43 anliegt, zur Erhöhung der Steifigkeit versehen. Wie in Fig. 5 zu sehen ist, sind in den Schenkeln des u-förmigen Blechs 47 Lamellen 72, die in kurzen Abständen durch Schlitze 73 getrennt sind, vorhanden. Durch die Lamellierung des Blechs 47 wird dieses in Richtung quer über das Pressband nachgiebig, so dass es sich unterstützt durch den Anpressdruck des Schlauches 46 an die Form des Pressbandes 21 bzw. der Umlenktrommel 20 quer über die Breite anpassen kann. Makrofehler wie Dickenunterschiede, Wellen oder Formfehler des Pressbandes werden somit ausgeglichen, indem sich das Blech 47 mit dem Schlauch 46 dieser Kontur anpasst.

Wie anhand der Fig. 3 und 4 ersichtlich, ist das Schleifkissen 44 in der Halterung 40 durch die beidseitig angebrachten Federn 48 in Axialrichtung, d.h. quer zur Vorlaufrichtung des Pressbandes 21 beweglich. Das Schleifkissen 44 wird mittels eines drehbar an einem Teil der Halterung 40 angebrachten Pleuels 49 über einen in Fig. 4 verdeckt liegenden Exzenter 50 von einem Motor 51 in Axialrichtung hin und her bewegt, so dass es eine in Axialrichtung oszillierende Bewegung ausführt. Da durch den Anpressdruck des Schleifkissens 44 das Schleifband 43 diese oszillierende Bewegung mitmacht, wird das Pressband 21 vom Schleifband 43 bearbeitet und festsitzende Harzrückstände und andere Verunreinigungen werden dabei gelockert.

Diese Axialbewegung des Schleifbandes 43 überlagert sich der Längsbewegung des Pressbandes 21, so dass die Schleifspuren also eine in etwa sinusförmige Gestalt besitzen, wie in Fig. 4 enter dem Bezugszeichen 52 angedeutet ist. Im fertigungstechnischen Sinne erhält man damit eigentlich kein Schleifen, sondern ein Honen. Wichtig ist für die Schleifbewegung, dass sich die Schleifspuren auf dem Pressband kreuzen. Damit wird nicht nur vermieden, dass sich Rillen oder Unebenheiten im Pressband ausbilden, sondern vorteilhafterweise wird durch den geringfügigen Materialabtrag auf der Pressbandoberfläche noch erreicht, dass sich Mikrorauhigkeiten auf der Pressbandoberfläche einebnen. Diese Wirkung wird unterstützt durch die Anordnung der Rollen für das Schleifband. In Vorlaufrichtung des Pressbandes gesehen ist zuerst die Abwickelrolle 41 und dann die Aufwickelrolle 42 angeordnet. Somit kommt das neue, unverbrauchte Schleifband 43 zuerst mit der Schmutzseite in Eingriff und reisst die gehärteten Harzreste und Kupferfolienreste auf. Dabei nützt sich das Schleifband langsam ab. Der verbrauchte, schon abgestumpfte Teil des Schleifbandes 43 kommt dann beim Vorlauf des Pressbandes 21 mit dem bereits vorgereinigten Teil des Pressbandes in Eingriff und bewirkt einen milden Angriff auf die Pressbandoberfläche, was ein Einebnen der zuvor schärfer angegriffenen Pressbandoberfläche bewirkt. In zweckmässig gewählten Abständen, beispielsweise wenn der von dem Schleifkissen 44 an das Pressband 21 angepresste Teil des Schleifbandes 43 völlig abgestumpft ist, wird vom Rechner oder einer Bedienungsperson gesteuert, das verbrauchte Stück des Schleifbandes auf die Aufwickelrolle 42 aufgewickelt, während von der Abwickelrolle 41 unverbrauchtes, frisches Schleifband nachgeführt wird.

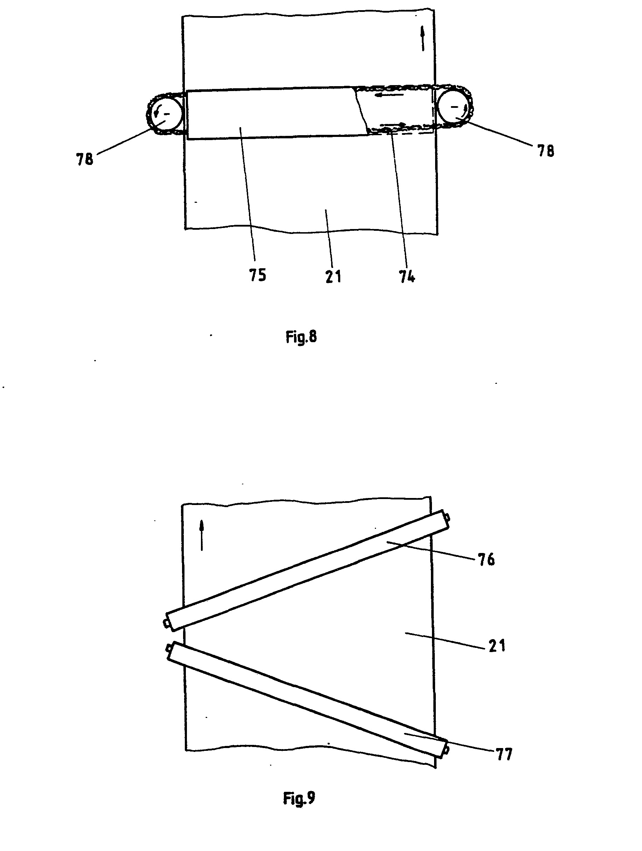

Eine weitere Ausbildungsform für die Pressbandschleifeinrichtung 39 ist in Fig. 8 in Draufsicht gezeigt. Diese Pressbandschleifeinrichtung, die wiederum in der Nähe der Auslaufzone 37 angebracht ist, besteht aus einer endlosen Kette 74, die über zwei Kettenräder 78 in Pfeilrichtung angetrieben endlos umläuft. Die Kettenräder 78 sind seitlich an der Doppelbandpresse 1 ausserhalb des Pressbandes 21 angebracht, so dass die Kette 74 über die gesamte Breite des Pressbandes bewegt wird. Beide Hälften der Kette 74 bewegen sich dabei in entgegengesetzter Richtung, wie in Fig. 8 anhand der Pfeile zu erkennen. Die Glieder der Kette 74 besitzen auf der dem Pressband 21 zugewandten Seite aufgeklebte Zieh- oder Honsteine und werden durch einen Niederhalter, der von einem streifenförmigen Blech 75 gebildet wird, so gegen das Pressband 21 gedrückt, dass die Zieh- oder Honsteine die Oberfläche des Pressbandes schleifend berühren. Durch die entgegengesetzte Laufrichtung der beiden Hälften der Kette 74 überlagert von der Bewegung des Pressbandes 21 erhält man wiederum sich kreuzende Schleifspuren auf der Pressbandoberfläche.

In Fig. 9 ist eine Pressbandschleifeinrichtung gezeigt, die durch zwei Schleifwalzen 76, 77 gebildet wird. Beide Schleifwalzen sind schräg zur Axialrichtung des Pressbandes 21 gestellt, wobei mit Axialrichtung die zur Vorlaufrichtung des Pressbandes senkrechte Richtung bezeichnet wird, und zwar die Schleifwalze 76 unter einem Winkel von rund +45 Grad und die Schleifwalze 77 unter einem Winkel von rund -45 Grad. Beide Schleifwalzen 76, 77 besitzen eine auf ihren Mantel aufgebrachte Körnung und werden unter Rotation entgegen der Vorlaufrichtung des Pressbandes gegen die Pressbandoberfläche angestellt, so dass sie diese schleifend berühren. Durch Überlagerung mit dem Vorschub des Pressbandes erhält man wiederum sich kreuzende Schleifspuren.

Der durch die Pressbandschleifeinrichtung 39 gelockerte Schmutz bzw. die gelösten Harz- und Kupferreste werden vom Pressband 21 in Richtung des Einlaufes in die Doppelbandpresse 1 transportiert. In der Nähe der Einlaufzone 38 ist eine Wischeinrichtung 69 angebracht, die dann diese gelösten Verunreinigungen vom Pressband aufnimmt. Die in diesen Ausführungsbeispielen gezeigten Pressbandschleifeinrichtungen sind in der Nähe der Auslaufzone 37 aus Platzgründen angebracht. Sie können auch näher zur Einlaufzone 38 angeordnet werden, wichtig ist jedoch, dass sie in Vorlaufrichtung des Pressbandes gesehen vor der Wischeinrichtung 69 angebracht sind.

Diese Wischeinrichtung 69, die in Fig. 7 zu sehen ist, besitzt ein Gehäuse 56, das am Pressengestell befestigt ist. In diesem Gehäuse 56 befinden sich eine Abwickelrolle 53 und eine Aufwickelrolle 54 für das Wischtuch 55, wobei deren Wickelkerne 57, 58 in Schlitzen 59, 60 des Gehäuses drehbar gelagert sind. Der Schlitz 60 ist so angebracht, dass das Wischtuch 55 auf der Aufwickelrolle 54 das Pressband 21 auf der Umlenktrommel 17 vor der Umlenkrolle 35 für die Kupferfolie 32, in Vorlaufrichtung des Pressbandes 21 gesehen, schleifend berührt. Das Wischtuch 55 auf der Abwickelrolle 53 berührt ebenfalls die einlaufende Kupferfolienbahn 32 kurz vor der Umlenktrommel 35, in Vorlaufrichtung der Kupferfolienbahn 32 gesehen. Sowohl der Wickelkern 57 bzw. 58 der Aufwickel- als auch der Abwickelrolle verschiebt sich unter dem Gewicht derselben soweit im Schlitz 59 bzw. 60, dass das Wischtuch auf den Rollen immer fest an der Pressband- oder Kupferfolienoberfläche anliegt.

Da sich die Kupferfolienbahn 32 bewegt, gleitet deren Oberfläche am stehenden Wischtuch 55 auf der Abwickelrolle 53 entlang und der auf der dem Schichtstoffkern abgewandten Oberfläche der Kupferfolienbahn liegende Schmutz, die Staubpartikel und abgebrochenen Dentriten werden vom Wischtuch 55 festgehalten. Solche abgebrochenen Dentriten kommen von der dem Schichtstoffkern zugewandten Oberfläche der Kupferfolie her. Zur Haftungsverbesserung der Kupferfolie auf dem Schichtstoff wird diese mit einem sogenannten Treatment versehen, bei dem die Oberfläche unter Ausbildung von Dentriten aufgerauht wird. Einzelne solcher Dentriten können jedoch abbrechen, wenn die Kupferfolie auf der Rolle aufgewickelt ist und dann mit der Kupferfolienbahn 32 in Richtung Doppelbandpresse 1 transportiert werden. Die zweite noch saubere Oberfläche des Wischtuches 55 auf der Aufwickelrolle 54 gleitet auf der sich bewegenden Oberfläche des Pressbandes 21 und nimmt den durch die Pressbandschleifeinrichtung 39 gelösten Schmutz und die Harz- und Kupferrückstände auf, so dass hinter der Aufwickelrolle 54 die Oberfläche des Pressbandes 21 wieder blank ist. In bestimmten Zeitabständen wird die Aufwickelrolle 54 ein Stück, das in etwa der Länge der einander berührenden Flächen zwischen Wischtuch 55 und Pressband 21 bzw. der Kupferfolienbahn 32 entspricht, weitergedreht, so dass das verschmutzte Wischtuch aufgewickelt und unverbrauchtes Wischtuch mit dem Pressband und der Kupferfolienbahn in Eingriff kommt. Dieses Weiterdrehen kann vom Rechner oder der Steuerung automatisch nach vorherbestimmten Zeiten bzw. in Abhängigkeit vom zurückgelegten Weg des Pressbandes durchgeführt werden. Falls gewünscht kann das Weiterdrehen auch dann erfolgen, wenn es ein Bedienungsmann aufgrund visueller Beurteilung der Verschmutzung des Wischtuches 55 für erforderlich hält.

Das Wischtuch 55 besteht aus einem Fasergewebe aus voluminösem Material, beispielsweise Flanell oder Trikot, wobei die Staubkörner und die Schmutzteilchen sich in dem Fasergewirk verfangen und darin hängenbleiben. Dieser Effekt kann verstärkt werden, indem das Wischtuch mit einem Alkohol oder einer etwas klebrigen Flüssigkeit getränkt wird. Als besonders geeignet hat sich für das Wischtuch auch ein Kunststoffvlies, das aus sehr feinen, teilweise miteinander verschweissten Polypropylenfasern besteht, erwiesen.

Es kann unter Umständen vorkommen, dass sich aus dem Wischtuch 55 Fasern lösen, die dann mit der Kupferfolienbahn 32 oder dem Pressband 21 in die Reaktionszone 30 transportiert werden könnten und dort durch Eindrücke in der Kupferfolienoberfläche wiederum zu Fehlstellen im kupferkaschierten Laminat führen könnten. Um diese Fasern zu entfernen, befindet sich in dem durch das Pressband 21 und der über die Umlenkrolle 35 einlaufenden Kupferfolienbahn 32 gebildeten Zwickel 67 ein Abstreifer 61. Dieser Abstreifer 61 besitzt zwei an einem gefederten Halter, der sich der Form des Zwickels 67 anpasst, angebrachte Lippen aus einem elastomeren Werkstoff, wobei eine Lippe 62 die Kupferfolienbahn 32 und die andere Lippe 63 das Pressband 21 schleifend berührt. Dadurch werden solche Fasern wiederum abgestreift und von Absauglippen 65, die direkt bei diesen Lippen 62, 63 liegen, aufgenommen. Die Absauglippen 65 stehen in Verbindung mit einem Absaugrohr 66, über das diese Fasern mittels Unterdruck vor der Einlaufzone 38 entfernt werden. Der Abstreifer 61 ist dem Zwickel 67 zugewandt mit einem Verstärkungsblech 64 versehen.

Der durch die Abwickelrolle 53, die Aufwickelrolle 54, dem zwischen der Auf- und Abwickelrolle liegenden Wischtuch 55, dem zwischen der Aufwickelrolle 54 und der Umlenkrolle 35 liegendem Teil des Pressbandes 21, dem Abstreifer 61, dem zwischen Umlenkrolle 35 und Abwickelrolle 53 liegenden Teil der Kupferfolienbahn 32 und dem Gehäuse 56 umschlossene Raum 68 kann durch Reinluft, die über Druck zugeführt wird, belüftet sein. Nachdem der auf dem Pressband oder der Kupferfolie haftende Schmutz mit dem Wischtuch 55 oder dem Abstreifer 61 entfernt ist, kommen diese Oberflächen- dann nur noch mit Reinluft in Berührung, die fast keine Staubteilchen enthält, die sich auf diesen Oberflächen absetzen könnten. Am Ende des Reinluftraums 68 wird die Kupferfolienbahn 32 mittels der Umlenkrolle 35 an das Pressband 21 angelegt, womit dann beide Oberflächen sich gegenseitig vor neu absetzendem Staub schützen. Falls notwendig, kann der Zwikkel 67 ebenfalls mit Reinluft belüftet sein. Unter Umständen kann es auch genügen, nur den Zwikkel 67 ohne den Raum 68 mit Reinluft zu belüften.

Sowohl die Funktion der Pressbandschleifeinrichtung 39 als auch der Wischeinrichtung 69 wurde an der oberen Pressbandeinheit, die von den Umlenkrollen 17, 20 und dem Pressband 21 gebildet wird, erläutert. Auch an der vom Pressband 22 und den Umlenktrommeln 18, 19 gebildeten unteren Pressbandeinheit werden solche Einrichtungen angebracht. Dabei befindet sich eine weitere Pressbandschleifeinrichtung 70 an der Umlenktrommel 19 in der Nähe der Auslaufzone 37 und eine Wischeinrichtung 71 mit einem Abstreifer 61 an der Umlenktrommel 18 in der Nähe der Einlaufzone 38.

**Patentansprüche**

1. Doppelbandpresse (1) mit zwei in einem Pressengestell übereinanderliegenden Preßbandeinheiten, die wiederum jeweils zwei drehbar gelagerte Umlenktrommeln (17, 20 bzw. 18, 19) und ein über diese Umlenktrommeln (17, 20 bzw. 18, 19) gespanntes Preßband (21 bzw. 22) besitzen und zwischen dem unteren Trum des oberen Preßbandes (21) und dem oberen Trum des unteren Preßbandes (22) die Druck ausübende Reaktionszone (30) bilden, zur kontinuierlichen Herstellung kupferkaschierter Laminate (16), die sich aus einem Schichtstoffkern mit an dessen Oberflächen fest haftenden Kupferfolien zusammensetzen, wobei die Schichtstoffbahnen (34) für den Schichtstoffkern und die Kupferfolienbahnen (32, 33) vor der Doppelbandpresse (1) von Rollen (5, 6, 7) abgezogen werden, die Kupferfolienbahnen (32, 33) mittels Umlenkrollen (35, 36) an das Preßband (21, 22) im Bereich der einlaufseitigen Umlenktrommel (17, 18) angelegt werden, in diesem Bereich eine Einrichtung zum Abstreifen von Schmutzteilchen vom Preßband (21, 22) und der Kupferfolienbahn (32, 33) angeordnet ist, und die Schichtstoffbahnen (34) mit den Kupferfolienbahnen (32, 33) dann vor der Reaktionszone (30) zu einem Schichtgebilde zusammengeführt werden, das anschließend in der Reaktionszone (30) der Doppelbandpresse (1) zu einer kupferkaschierten Laminatbahn (16) verpreßt wird, dadurch gekennzeichnet, daß in Vorlaufrichtung des Preßbandes (21, 22) gesehen vor der Einlaufzone (38) in die Doppelbandpresse (1) eine Preßbandschleifeinrichtung (39, 70) für das Preßband (21, 22) angebracht ist, die solche Bewegungen ausführt, daß sich auf dem Preßband (21, 22) kreuzende Schleifspuren (52) ergeben und die zum Lösen von auf dem Preßband (21, 22) haftenden, gehärteten Harzresten oder sonstigen Verschmutzungen dient und daß die hinter der Preßbandschleifeinrichtung (39, 70), in unmittelbarer Nähe der Einlaufzone (38) angeordnete Einrichtung zum Abstreifen von Schmutzteilchen aus einer Wischeinrichtung (69, 71) zur Aufnahme sowohl der gelösten Verschmutzung vom Preßband (21, 22) als auch der Staubkörner oder sonstiger Schmutzteilchen, die auf der, dem Preßband (21, 22) zugewandten Oberfläche der in die Doppelbandpresse (1) einlaufenden Kupferfolienbahn (32, 33) haften, besteht.

2. Doppelbandpresse nach Anspruch 1, dadurch gekennzeichnet, dass die Pressbandschleifeinrichtung (39, 70) in der Nähe der Auslaufzone (37) an der auslaufseitigen Umlenktrommel (20, 19) angebracht ist.

3. Doppelbandpresse nach Anspruch 1 oder 2, dadurch gekennzeichnet, dass die Pressbandschleifeinrichtung (39, 70) ein Schleifband (43) besitzt, das von einer Abwickelrolle (41) ab- und von einer Aufwickelrolle (42) aufgewickelt wird, zwischen diesen Rollen (41, 42) eine Anpressvorrichtung, die oszillierende Bewegungen in zur Vorlaufrichtung des Presbandes (21, 22) senkrechte Richtungen durchführt, das Schleifband (43) an die Oberfläche des Pressbandes (21, 22) andrückt und die Rollen (41, 42) in einer am Pressengestell befestigten Halterung (40) gelagert sind.

4. Doppelbandpresse nach Anspruch 3, dadurch gekennzeichnet, dass die Abwickelrolle (41) in Vorlaufrichtung des Pressbandes (21, 22) vor der Aufwickelrolle (42) angeordnet ist.

5. Doppelbandpresse nach Ansprüche 3 und 4, dadurch gekennzeichnet, dass die Anpresseinrichtung aus einem Schleifkissen (44) besteht, das zur Erzeugung des Anpressdrucks einen Pressluftgefüllten Schlauch (46) besitzt.

6. Anpresseinrichtung nach Anspruch 5, dadurch gekennzeichnet, dass der Schlauch (46) von einem u-förmig gebogenen Blech (47), das sich zwischen Schleifband (43) und Schlauch (46) befindet, abgestützt ist.

7. Anpresseinrichtung nach Anspruch 6, dadurch gekennzeichnet, dass die Schenkel des u-förmigen Bleches (47) durch Schlitze (73) mit Lamellen (72) versehen sind.

8. Doppelbandpresse nach einem der Ansprüche 3 bis 7, dadurch gekennzeichnet, dass die Anpresseinrichtung in einer Halterung (40) mittels Blattfedern (48) in Richtung senkrecht zur Vorlaufrichtung des Pressbandes beweglich gelagert ist und mittels eines Motors (51) und Exzenters (50) über ein Pleuel (49) in oszillierende Bewegung versetzt wird.

9. Doppelbandpresse nach Anspruch 8, dadurch gekennzeichnet, dass die der Halterung (40) abgewandten Enden der Blattfedern (48) am Pressengestell befestigt sind.

10. Doppelbandpresse nach einem der Ansprüche 3 bis 9, dadurch gekennzeichnet, dass nachdem die Körnung des Teils des Schleifbandes (43), das an das Pressband (21, 22) angedrückt wird, abgenutzt ist, das Schleifband (43) um die Andrücklänge der Anpresseinrichtung zwischen Auf- und Abwickelrolle (41, 42) weitergespult wird, so dass unverbrauchtes Schleifband (43) in Eingriff mit dem Pressband (21, 22) kommt.

11. Doppelbandpresse nach einem der Ansprüche 3 bis 9, dadurch gekennzeichnet, dass das Schleifband (43) nach jeweils einem vorherbestimmten Zeitabschnitt um die Andrücklänge der Anpresseinrichtung zwischen Auf- und Abwickelrolle (41,42) weitergespult wird.

12. Doppelbandpresse nach Anspruch 1 oder 2, dadurch gekennzeichnet, dass die Pressbandschleifeinrichtung (39, 70) aus einer Kette (74) besteht, auf deren Gliedern der Pressbandoberfläche zugewandt sich Zieh- oder Honsteine befinden, jedes Glied der Kette (74) durch einen Niederhalter gegen das Pressband gedrückt wird und die Kette (74) über zwei seitlich neben dem pressband (21, 22), am Pressengestell angebrachten Kettenrädern (78) angetrieben wird und endlos umläuft, wobei sich die Schleifspuren von den auf den beiden Hälften der Kette angebrachten Zieh- oder Honsteine kreuzen.

13. Doppelbandpresse nach Anspruch 12, dadurch gekennzeichnet, dass der Niederhalter durch ein streifenförmiges Blech (75) gebildet wird.

14. Doppelbandpresse nach Anspruch 12 oder 13, dadurch gekennzeichnet, dass die Zieh- oder Honsteine auf den Kettengliedern aufgeklebt sind.

15. Doppelbandpresse nach Anspruch 1 oder 2, dadurch gekennzeichnet, dass die Pressbandschleifeinrichtung (39, 70) aus zwei am Pressband (21, 22) angedrückten, an ihrer Mantelfläche schleifenden Walzen (76, 77) besteht, die schräggestellt sind, so dass sich die Schleifspuren auf der Pressbandoberfläche kreuzen.

16. Doppelbandpresse nach einem der Ansprüche 1 bis 15, dadurch gekennzeichnet, dass in der Nähe der Einlaufzone (38) unmittelbar vor der Umlenkrolle (35, 36), mit der die Kupferfolienbahn (32, 33) an das Pressband (21, 22) auf der Umlenktrommel (17, 18) angelegt wird, die Wischeinrichtung (69, 71) angebracht ist.

17. Doppelbandpresse nach Anspruch 16, dadurch gekennzeichnet, dass die Wischeinrichtung (69, 71) aus einer Abwickelrolle (53) und einer Aufwickelrolle (54) für das bahnförmige Wischtuch (55) besteht, das Wischtuch auf der Abwickelrolle (53) mit einem Teil deren Umfangs auf der dem Pressband (21, 22) zugewandten Oberfläche der auf die Einlaufzone (38) zulaufenden Kupferfolienbahn (32, 33) gleitend aufliegt und das Wischtuch auf der Aufwickelrolle (54) mit einem Teil deren Umfangs auf der Pressbandoberfläche des Pressbands (21, 22) gleitend aufliegt.

18. Doppelbandpresse nach Anspruch 17, dadurch gekennzeichnet, dass die Wickelrichtungen der beiden Rollen (53, 54) entgegengesetzt sind, so dass eine Oberfläche des Wischtuchs (55) auf der Kupferfolienbahn (32, 33) und die andere Oberfläche des Wischtuchs (55) auf dem Pressband (21, 22) aufliegt.

19. Doppelbandpresse nach Anspruch 17 oder 18, dadurch gekennzeichnet, dass die Abwickelrolle (53) und die Aufwickelrolle (54) in einem Gehäuse (56) angebracht sind, das am Pressengestell befestigt ist und mit Schlitzen (59, 60) zum Einhängen der Wickelkerne (57, 58) der Rollen (53, 54) versehen ist.

20. Doppelbandpresse nach Anspruch 19, dadurch gekennzeichnet, dass die Schlitze (59, 60) so angebracht sind, dass die Rollen (53, 54) unter ihrem eigenen Gewicht auf der Oberfläche der Kupferfolienbahn (32, 33) oder des Pressbandes (21, 22) aufliegen.

21. Doppelbandpresse nach einem der Ansprüche 17 bis 20, dadurch gekennzeichnet, dass das Wischtuch (55) aus einem Textilgewebe, wie Flanell oder Trikot, besteht.

22. Doppelbandpresse nach einem der Ansprüche 17 bis 20, dadurch gekennzeichnet, dass das Wischtuch (55) aus einem Gewebe von feinen, miteinander verschweissten Polypropylenfasern besteht.

23. Doppelbandpresse nach Anspruch 21 oder 22, dadurch gekennzeichnet, dass das Gewebe des Wischtuchs (55) mit einer Verunreinigungen lösenden Substanz getränkt ist.

24. Doppelbandpresse nach Anspruch 23, dadurch gekennzeichnet, dass das Gewebe des Wischtuchs (55) mit Alkohol getränkt ist.

25. Doppelbandpresse nach Anspruch 21 oder 22, dadurch gekennzeichnet, dass das Gewebe des Wischtuchs (55) mit einer klebrigen Substanz getränkt ist.

26. Doppelbandpresse nach einem der Ansprüche 17 bis 25, dadurch gekennzeichnet, dass sobald der die Pressband- oder Kupferfolienbahnoberfläche berührende Teil des Wischtuchs (55) einen bestimmten Grad an Verschmutzung erreicht hat, das Wischtuch (55) ungefähr um die Länge der einander berührenden Teile zwischen der Auf- und Abwickelrolle (53, 54) weitergespult wird, so dass unverbrauchtes Wischtuch (55) mit den jeweiligen Oberflächen in Berührung kommt.

27. Doppelbandpresse nach einem der Ansprüche 17 bis 25, dadurch gekennzeichnet, dass jeweils nach Ablauf eines vorherbestimmten Zeitabschnitts das Wischtuch (55) ungefähr um die Länge der einander berührenden Teile zwischen Wischtuch (55) und Pressband (21, 22) bzw. Kupferfolienbahn (32, 33) zwischen der Auf- und Abwickelrolle (53, 54) weitergespult wird.

28. Doppelbandpresse nach einem der Ansprüche 1 bis 27, dadurch gekennzeichnet, dass in Vorlaufrichtung des Pressbandes (21, 22) gesehen hinter der Wischeinrichtung (69, 71) zwischen der an der Umlenkrolle (35, 36) anliegenden Kupferfolienbahn (32, 33) und dem Pressband (21, 22) ein Abstreifer (61) angebracht ist, der aufgrund seiner Eigenelastizität mit einer Lippe (62) die Kupferfolienbahn (32, 33) und mit der anderen Lippe (63)
das Pressband (21, 22) gleitend berührt.

29. Doppelbandpresse nach Anspruch 28,
dadurch gekennzeichnet, dass die Lippen (62, 63)
aus einem Elastomer bestehen.

30. Doppelbandpresse nach Anspruch 28 oder
29, dadurch gekennzeichnet, dass unmittelbar bei
den Lippen (62, 63) an der der Einlaufzone (38)
abgewandten Seite Absauglippen (65), die über
ein Absaugrohr (66) an Unterdruck angeschlossen sind und zur Entfernung von Fasern und
Staub dienen, angeordnet sind.

31. Doppelbandpresse nach einem der Ansprüche 1 bis 30, dadurch gekennzeichnet, dass der
Raum 68, der durch die Abwikkelrolle (53), die
Aufwickelrolle (54), dem zwischen der Auf- und
Abwickelrolle liegenden Wischtuch (55), dem
zwischen der Aufwickelrolle (54) und der Umlenkrolle (35) liegendem Teil des Pressbandes (21,
22), dem Abstreifer (61), dem zwischen der
Umlenkrolle (35) und der Abwickelrolle (53)
liegenden Teil der Kupferfolienbahn (32, 33) und
den Seitenwänden des Gehäuses (56) begrenzt
wird, mit über Druck zugeführter Reinluft belüftet
wird.

32. Doppelbandpresse nach einem der Ansprüche 1 bis 31, dadurch gekennzeichnet, dass der
zwischen der Einlaufzone (38) und dem Raum (68)
liegende Zwickel (67), der von dem Pressband (21,
22), der Kupferfolienbahn (32, 33) auf der Umlenkrolle (35) und dem Abstreifer (61) begrenzt wird,
mit über Druck zugeführter Reinluft belüftet wird.

## Revendications

1. Presse à double bande (1) avec deux unités
de bandes de pressage situées l'une sur l'autre
dans un bâti de pressage, possédant chacune
deux tambours de rotation (17, 20, 18, 19 respectivement), supportés de façon à pouvoir tourner,
et chacune une bande de pressage tendue (21, 22
respectivement), sur ces tambours de rotation
(17, 20, 18, 19, respectivement), et qui forment
entre le brin inférieur de la bande supérieure (21)
de pressage et le brin supérieur de la bande
inférieure (22) de pressage la zone (30) de réaction où s'exerce la pression, pour la fabrication en
continu d'électrolaminés (16) recouverts de cuivre, qui se composent d'un noyau multi-couches
avec sur ses surfaces des feuilles de cuivre fixées
de façon ferme, et pour laquelle les bandes (34)
de matière multi-couches pour le noyau multi-
couches et les bandes 32, 33) des feuilles de
cuivre sont tirées vers la presse (1) à double
bande par des rouleaux (5, 6, 7), les bandes (32,
33) des feuilles de cuivre étant amenées au
moyen des rouleaux (35, 36) de rotation contre la
bande (21, 22) de pressage dans la zone du
tambour (17, 18) de rotation du côté de l'entrée,
un dispositif étant installé dans cette région pour
l'élimination des particules de saleté de la bande
(21, 22) de pressage de la bande (32, 33) des
feuilles de cuivre, les bandes (34) de matière
multi-couches étant ensuite conduites ensemble avec les bandes (32, 33) de feuilles de cuivre
devant la zone (30) de réaction en se présentant
comme un produit multi-couches, lequel est finalement comprimé dans la zone (30) de réaction de
la presse (1) à double bande en une ligne (16)
d'électrolaminé recouvert de cuivre, caractérisée
en ce que, vu dans la direction de l'avancement
de la bande (21, 22) de pressage, avant la zone
(38) d'entrée dans la presse (1) à double bande,
un dispositif (39, 70) de meulage de la bande de
pressage pour la bande (21, 22) de pressage est
installé, qui exécute des mouvements tels que
des traces (52) de meulage, qui se croisent, se
forment sur la bande (21, 22) de pressage, et qui
sert à détacher de la bande (21, 22) de pressage
des restes de résine durcie bien accrochées ou
d'autres saletés, et en ce que, en aval du dispositif
(39, 70) de meulage de la bande de pressage, à
proximité immédiate de la zone (38) d'entrée, un
agencement est installé, constitué d'un dispositif
(69, 71) d'essuyage pour l'élimination de particules de saleté, et la réception, non seulement de
la saleté libérée de la bande (21, 22) de pressage,
mais aussi les grains de poussière ou d'autres
particules de saleté, qui s'accrochent à la surface
de la bande (32, 33) des feuilles de cuivre, du côté
de la bande (21, 22) de pressage, entrant dans la
presse (1) à double bande.

2. Presse à double bande selon la revendication
1, caractérisée en ce que le dispositif (39, 70) de
meulage de la bande de pressage est disposé
dans le voisinage de la zone (37) de sortie, sur le
tambour (20, 19) de rotation, côté sortie.

3. Presse à double bande selon les revendications 1 ou 2, caractérisée en ce que le dispositif
(39, 70) de meulage de la bande de pressage
possède une bande (43) de meulage, qui se
déroule d'un rouleau (41) de déroulage et s'enroule sur un rouleau (42) d'enroulage, et qu'entre
ces rouleaux (41, 42) un dispositif de pressage
exécute des mouvements oscillants dans une
direction perpendiculaire à la direction d'avancement de la bande (21, 22) de pressage, la bande
(43) de meulage s'appuyant sur la surface de la
bande (21, 22) de pressage, et les rouleaux (41,
42) étant disposés dans un système (40) de
maintien fixé au bâti de pression.

4. Presse à double bande selon la revendication
3, caractérisée en ce que le rouleau (41) de
déroulage, dans la direction d'avancement de la
bande (21, 22) de pressage, est installé en amont
du rouleau (42) d'enroulage.

5. Presse à double bande selon les revendications 3 et 4, caractérisée en ce que le dispositif de
pressage est constitué d'un coussin (44) de meulage, qui possède un tuyau (46) rempli d'air
comprimé pour produire la pression d'appui.

6. Presse à double bande selon la revendication
5, caractérisée en ce que le tuyau (46) s'appuie sur
une tôle (47) pliée en forme de U et qui se trouve
entre la bande (43) de meulage et le tuyau (46).

7. Presse à double bande selon la revendication
1, caractérisée en ce que les montants de la tôle
(47) en forme de U sont pourvus de fentes (73)
avec des lamelles (72).

8. Presse à double bande selon l'une quelconque des revendications 3 à 7, caractérisée en ce que le dispositif de pressage est disposé de façon mobile dans un système (40) de maintien au moyen de ressorts (48) à lames dans une direction perpendiculaire à la direction d'avancement de la bande de pressage, et que ce dispositif de pressage est déplacé au moyen d'un moteur (51) et d'un excentrique (50) par l'intermédiaire d'une bielle (49) dans un mouvement alternatif.

9. Presse à double bande selon la revendication 8, caractérisée en ce que les extrémités des ressorts (48) à lames opposées au système (40) de maintien sont fixées au bâti de pressage.

10. Presse à double bande selon l'une quelconque des revendications 3 à 9, caractérisée en ce que, lorsque la granulation de la partie de la bande (43) de meulage, qui s'appuie sur la bande (21, 22) de pressage, a été usée, la bande (43) de meulage est enroulée davantage, de la longueur d'appui du dispositif de pressage entre les rouleaux d'enroulage (42) et de déroulage (41), de sorte que la bande (43) non encore utilisée vienne en contact avec la bande (21, 22) de pressage.

11. Presse à double bande selon l'une quelconque des revendications 3 à 9, caractérisée en ce que la bande (43) de meulage, chaque fois après un certain laps de temps prédéterminé, est enroulée de la longueur d'appui du dispositif de pressage, entre les rouleaux d'enroulage (42) et de déroulage (41).

12. Presse à double bande selon les revendications 1 ou 2, caractérisée en ce que le dispositif (39, 70) de meulage de la bande de pressage est constitué d'une chaîne (74), sur les éléments de laquelle se trouve une granulation du côté de la surface de la bande de pressage, chaque élément de la chaîne (74) étant appuyé par un support inférieur contre la bande de pressage, et en ce que la chaîne est entraînée par deux roues dentées (78) disposées latéralement à côté de la bande (21, 22) de pressage et fixées au bâti de pressage, et tourne sans fin, grâce à quoi les traces de meulage faites par les granulation disposées sur les deux moitiés de la chaîne se croisent.

13. Presse à double bande selon la revendication 12, caractérisée en ce que le support inférieur est formé par une tôle (75) en forme de passage.

14. Presse à double bande selon les revendications 12 ou 13, caractérisée en ce que les granulations sont collées sur les éléments de la chaîne.

15. Presse à double bande selon les revendications 1 ou 2, caractérisée en ce que le dispositif (39, 70) est constitué de deux rouleaux (76, 77) dont la surface périphérique sert au meulage, qui sont appuyés sur la bande (21, 22) de pressage, et disposés de façon oblique, de sorte que les traces de meulage sur la surface de la bande de pressage se croisent.

16. Presse à double bande selon l'une quelconque des revendications 1 à 15, caractérisée en ce que le dispositif (69, 71) d'essuyage est installé dans le voisinage de la zone (38) d'entrée, directement avant le rouleau (35, 36) de rotation, avec lequel la bande (32, 33) des feuilles de cuivre est posée sur la bande (21, 22) de pressage, sur le tambour (17, 18) de rotation.

17. Presse à double bande selon la revendication 16, caractérisée en ce que le dispositif (69, 71) d'essuyage est constitué d'un rouleau (53) de déroulage et d'un rouleau (54) d'enroulage pour le tissu (55) d'essuyage en forme de bande, le tissu d'essuyage sur le rouleau (53) de déroulage entourant une partie de la périphérie de ce dernier et glissant sur la surface adjacente à la bande (21, 22) de pressage de la bande (32, 33) de la feuille de cuivre qui avance dans la zone (38) d'entrée, et le tissu d'essuyage sur le rouleau (54) d'enroulage entourant une partie de la périphérie de ce dernier et glissant sur la surface de la bande (21, 22) de pressage.

18. Presse à double bande selon la revendication 17, caractérisée en ce que les sens de rotation des deux rouleaux (53, 54) sont opposés, de sorte qu'une surface du tissu (55) d'essuyage repose sur la bande (32, 33) de la feuille de cuivre, et que l'autre surface du tissu (55) d'essuyage repose sur la bande (21, 22) de pressage.

19. Presse à double bande selon la revendication 17 ou 18, caractérisée en ce que le rouleau (53) de déroulage et le rouleau (54) d'enroulage sont disposés dans un boîtier, qui est fixé au bâti de pressage, et qui est muni de fentes (59, 60) pour mettre en place les axes (57, 58) d'enroulement des rouleaux (53, 54).

20. Presse à double bande selon la revendication 19, caractérisée en ce que les fentes (59, 60) sont disposées de telle sorte que les rouleaux (53, 54), sous leur propre poids, reposent sur les surfaces de la bande (32, 33) de la feuille de cuivre ou de la bande (21, 22) de pressage.

21. Presse à double bande selon la revendication 17 à 20, caractérisée en ce que le tissu (55) d'essuyage est constitué d'un textile, tel que la flanelle ou le tricot.

22. Presse à double bande selon la revendication 17 à 20, caractérisée en ce que le tissu (55) d'essuyage est constitué d'un tissu de fibres de polypropylène, fines et soudées ensemble.

23. Presse à double bande selon la revendication 21 ou 22, caractérisée en ce que le tissu (55) d'essuyage est imprégné d'une substance dissolvant les impuretés.

24. Presse à double bande selon la revendication 23, caractérisée en ce que le tissu (55) d'essuyage est imprégné d'alcool.

25. Presse à double bande selon les revendications 21 ou 22, caractérisée en ce que le tissu (55) d'essuyage est imprégné d'une substance collante.

26. Presse à double bande selon les revendications 17 à 25, caractérisée en ce que, dès que la partie du tissu (55) d'essuyage en contact avec la surface de la bande de pressage ou avec la surface de la bande de la feuille de cuivre a atteint un certain degré de salissure, le tissu (55) d'essuyage est déroulé environ de la longueur des parties mutuellement en contact entre les rouleaux de déroulage (53) et d'enroulage (54), de sorte que du tissu (55) d'essuyage non encore utilisé vienne en contact avec chaque surface.

27. Presse à double bande selon l'une quelconque des revendications 17 à 25, caractérisée en ce que, chaque fois, après un laps de temps prédéterminé, le tissu (55) d'essuyage est déroulé environ de la longueur des parties mutuellement en contact entre le tissu (55) d'essuyage et la bande (21, 22) de pressage, ou de la bande (32, 33) de la feuille de cuivre, entre les rouleaux de déroulage (53) et d'enroulage (54).

28. Presse à double bande selon l'une quelconque des revendications 1 à 27, caractérisée en ce que, vu dans la direction de l'avancement de la bande (21, 22) de pressage, un système (61) d'élimination est disposé derrière le dispositif (69, 71) d'essuyage, entre la bande (32, 33) de la feuille de cuivre posée sur le rouleau (35, 36) de rotation et la bande (21, 22) de pressage, ce système (61) d'élimination, du fait de son élasticité propre, est en contact glissant par une lèvre (62) avec la bande (32, 33) de la feuille de cuivre, et par l'autre lèvre (63) avec la bande (21, 22) de pressage.

29. Presse à double bande selon la revendication 28, caractérisée en ce que les lèvres (62, 63) sont réalisées en un matériau élastomère.

30. Presse à double bande selon les revendications 28 ou 29, caractérisée en ce que, directement contre les lèvres (62, 63), du côté opposé à la zone (38) d'entrée, des lèvres (65) d'aspiration sont disposées qui, reliées à un tube (66) d'aspiration, servent par dépression à éliminer les fibres et la poussière.

31. Presse à double bande selon l'une quelconque des revendications 1 à 30, caractérisée en ce que l'espace (68) qui est délimité par le rouleau (53) de déroulage, le rouleau (54) d'enroulage, le tissu (55) d'essuyage situé entre les rouleaux d'enroulage et de déroulage, la partie de la bande (21, 22) de pressage située entre le rouleau (54) d'enroulage et le rouleau (35) de rotation, le système (61) d'élimination, la partie de la bande (32, 33) de la feuille de cuivre située entre le rouleau (35) de rotation et le rouleau (53) de déroulage, et les côtés latéraux du boîtier (56), est ventilé par de l'air pur, introduit sous pression.

32. Presse à double bande selon l'une quelconque des revendications 1 à 31, caractérisée en ce que le coin (67) situé entre la zone (38) d'entrée et l'espace (68) et qui est délimité par la bande (21, 22) de pressage, la bande (32, 33) de la feuille de cuivre sur le rouleau (35) de rotation et le système (61) d'élimination, est ventilé par de l'air pur, introduit sous pression.

**Claims**

1. Double belt press (1), with two press belt units which lie one above the other in a press frame and each in turn respectively have two rotatably borne deflecting drums (17, 20 or 18, 19) and a press belt (21 or 22) stretched over these deflecting drums (17, 20 or 18, 19) and form the reaction zone (30) exerting pressure between the lower run of the upper press belt (21) and the upper run of the lower press belt (22), for the continuous production of copper-clad laminates (16), which are composed of a laminated material core with copper foils firmly adhering at its surfaces, wherein the laminated material webs (34) for the laminated material core and the copper foil webs (32, 33) are drawn off from rolls (5, 6, 7) upstream of the double belt press (1), the copper foil webs (32, 33) are laid by means of deflecting rollers (35, 36) against the press belt (21, 22) in the region of the deflecting drum (17, 18) at the inlet end, an equipment for the wiping-off of dirt particles from the press belt (21, 22) and the copper foil web (32, 33) is arranged in this region and the laminated material webs (34) with the copper foil web (32, 33) are then guided together upstream of the reaction zone (30) into a laminar formation which is subsequently pressed together into a copper-clad laminate web (16) in the reaction zone (30) of the double belt press (1), characterised thereby, that a press belt sanding equipment (39, 70) for the press belt (21, 22) is mounted in front — as seen in direction of advance of the press belt (21, 22) — of the inlet zone (38) into the double belt press (1), executes such movements that mutually crossing sanding tracks (52) result on the press belt (21, 22) and serves for the detaching of hardened resin residues or other contaminations adhering on the press belt (21, 22) and that the equipment for the wiping-off of dirt particles is arranged behind the press belt sanding equipment (39, 70) and in immediate proximity of the inlet zone (38) and consists of a wiping equipment (69, 71) for the reception of the contamination detached from the press belt (21, 22) as well as also of the dust grains or other dirt particles which adhere on that surface of the copper foil web (32, 33) running into the double belt press (1), which faces the press belt (21, 22).

2. Double belt press according to claim 1, characterised thereby, that the press belt sanding equipment (39, 70) is mounted in the proximity of the outlet zone (37) at the deflecting drum (20, 19) at the outlet end.

3. Double belt press according to claims 1 or 2, characterised thereby, that the press belt sanding equipment (39, 70) has a sanding belt (43), which is unreeled from an unreeling roll (41) and reeled onto a reeling roll (42), a pressing device between these rolls (41, 42), which performs oscillating movements in directions perpendicular to the direction of advance of the press belt (21, 22) and presses the sanding belt (43) against the surface of the press belt (21, 22) and the rolls (41, 42) are borne in a mounting fastened at the press frame.

4. Double belt press according to claim 3, characterised thereby, that the unreeling roll (41) is arranged in front of the reeling roll (41) in the direction of advance of the press belt (21, 22).

5. Double belt press according to claims 3 and 4, characterised thereby, that the pressing equipment consists of a sanding pad (44), which for the production of the contact pressure has a hose (46) filled with compressed air.

6. Double belt press according to claim 5, characterised thereby, that the hose (46) is supported by a metal plate (47), which is bent into U-shape and disposed between the sanding belt (43) and the hose (46).

7. Double belt press according to claim 6, characterised thereby, that the limbs of the U-shaped metal plate (47) are provided through slots (73) with laminae (72).

8. Double belt press according to one of the claims 3 to 7, characterised thereby, that the pressing equipment is borne to be movable in a direction perpendicular to the direction of advance of the press belt by means of leaf springs (48) in a mounting (40) and is set into oscillatory movement by way of a connecting rod (49) by means of a motor (51) and eccentrics (50).

9. Double belt press according to claim 8, characterised thereby, that those ends of the leaf springs (48), which are remote from the mounting (40), are fastened at the press frame.

10. Double belt press according to one of the claims 3 to 9, characterised thereby, that after the coarseness of that part of the sanding belt (43), which is pressed against the press belt (21, 22), has worn off, the sanding belt (43) is reeled further by the pressed-on length of the pressing equipment between the unreeling and reeling rolls (41, 42), so that unused sanding belt (43) comes into engagement with the press belt (21, 22).

11. Double belt press according to one of the claims 3 to 9, characterised thereby, that the sanding belt (43) is reeled further by the pressed-on length of the pressing equipment between the unreeling and reeling rolls (41, 42) each time after a predetermined time interval.

12. Double press belt according to claim 1 or 2, characterised thereby, that the press belt sanding equipment (39, 70) consists of a chain (74), on the links of which dies or honing stones are disposed facing the press belt surface, each link of the chain (74) is urged by a pressure foot against the press belt and the chain (74) is driven by way of two chain wheels (78) mounted at the press frame laterally beside the press belt (21, 22) and circulates endlessly, wherein the sanding tracks of the dies or honing stones mounted on both the halves of the chain cross one the other.

13. Double belt press according to claim 12, characterised thereby, that the presser foot is formed by a strip-shaped metal plate (75).

14. Double belt press according to claims 12 or 13, characterised thereby, that the dies or honing stones are glued onto the chain links.

15. Double press belt according to claim 1 or 2, characterised thereby, that the press belt sanding equipment (39, 70) consists of two rollers (76, 77), which are sanding at their shell surface, are urged against the press belt (21, 22) and which are set obliquely so that the sanding tracks on the press belt surface cross one the other.

16. Double belt press according to one of the claims 1 to 15, characterised thereby, that the wiping equipment (69, 71) is mounted in the proximity of the inlet zone (38) immediately in front of the deflecting roller (35, 36), by which the copper foil web (32, 33) is laid against the press belt (21, 22) on the deflecting drum (17, 18).

17. Double belt press according to claim 16, characterised thereby, that the wiping equipment (69, 71) consists of an unreeling roll (53) and a reeling roll (54) for the web-shaped wiping cloth (55), the wiping cloth on the unreeling roll (53) lies slidingly by a part of the circumference thereof on that surface of the copper foil web (32, 33) running towards the inlet zone (38), which faces the press belt (21, 22), and the wiping cloth on the reeling roll (54) lies slidingly by a part of the circumference thereof on the press belt surface of the press belt (21, 22).

18. Double belt press according to claim 17, characterised thereby, that the winding directions of both the rolls (53, 54) are mutually opposite so that one surface of the wiping cloth (55) lies on the copper foil web (32, 33) and the other surface of the wiping cloth (55) lies on the press belt (21, 22).

19. Double belt press according to claim 17 or 18, characterised thereby, that the unreeling roll (53) and the reeling roll (54) are mounted in a housing (56), which is fastened at the press frame and provided with slots (59, 60) for the hooking-in of the winding cores (57, 58) of the rolls (53, 54).

20. Double belt press according to claim 19, characterised thereby, that the slots (59, 60) are so arranged that the rolls (53, 54) lie under their own weight on the surface of the copper foil web (32, 33) or of the press belt (21, 22).

21. Double belt press according to one of the claims 17 to 20, characterised thereby, that the wiping cloth (55) consists of a textile fabric such as flannel or cotton jersey.

22. Double belt press according to one of the claims 17 to 20, characterised thereby, that the wiping cloth (55) of a fabric of fine polypropylene fibres which have been welded together.

23. Double belt press according to claims 21 or 22, characterised thereby, that the fabric of the wiping cloth (55) is impregnated with a substance dissolving impurities.

24. Double belt press according to claim 23, characterised thereby, that the fabric of the wiping cloth (55) is impregnated with alcohol.

25. Double belt press according to claim 21 or 22, characterised thereby, that the fabric of the wiping cloth (55) is impregnated with a sticky substance.

26. Double belt press according to one of the claims 17 to 25, characterised thereby, that as soon as that part of the wiping cloth (55), which touches the surface of the press belt or of the copper foil web, has reached a certain degree of contamination, the wiping cloth (55) is reeled further by approximately the length of the mutually touching parts between the reeling and unreeling rolls (53, 54) so that unused wiping cloth (55) comes into contact with the respective surfaces.

27. Double belt press according to one of the claims 17 to 25, characterised thereby, that the wiping cloth (55) is reeled further by approximately the length of the mutually touching parts between wiping cloth (55) and either the press belt (21, 22) or the copper foil web (32, 33) between the reeling and unreeling rolls (53, 54) each time after a predetermined time interval.

28. Double belt press according to one of the claims 1 to 27, characterised thereby, that a wiper (61), which by reason of its inherent elasticity slidingly touches the copper foil web (32, 33) by one lip (62) and the press belt (21, 22) by the other lip (63), is mounted between the copper foil belt (32, 33) lying against the deflecting roller (35, 36) and the press belt (21, 22) behind the wiping equipment (69, 71) as seen in the direction of advance of the press belt (21, 22).

29. Double belt press according to claim 28, characterised thereby, that the lips (62, 63) consist of an elastomer.

30. Double belt press according to claim 28 or 29, characterised thereby, that suction lips (65), which are connected by way of a suction tube (66) to underpressure and serve for the removal of fibres and dust, are arranged directly at the lips (62, 63) at the side remote from the inlet zone (38).

31. Double belt press according to one of the claims 1 to 30, characterised thereby, that the space (68), which is bounded by the unreeling roll (53), the reeling roll (54), the wiping cloth (55) lying between the reeling roll and the unreeling roll, the part of the press belt (21, 22) lying between the reeling roll (54) and the deflecting roller (35), the wiper (61), the part of the copper foil web (32, 33) lying between the deflecting roller (35) and the unreeling roll (53) and by the side walls of the housing (56), is ventilated by clean air supplied under pressure.

32. Double belt press according to one of the claims 1 to 31, characterised thereby, that the wedge-shaped space (67), which lies between the inlet zone (38) and the space (68) and which is bounded by the press belt (21, 22), the cooper foil web (32, 33) on the deflecting roller (35) and by the wiper (61), is ventilated by clean air supplied under pressure.

Fig. 1

EP 0 215 392 B1

Fig.2

42

48

48

49

51

40

44

41

21

40

20

50

Fig.3

3

Fig.4

EP 0 215 392 B1

Fig.5

Fig.6

Fig.7

6

78

75    21    74

Fig.8

76

21

77

Fig.9